# FASCICULE DE BREVET EUROPEEN

(11) **EP 3 035 070 B1**
(45) Date de publication et mention de la délivrance du brevet: **17.02.2021**
(21) Numéro de dépôt: 15200525.2
(22) Date de dépôt: 16.12.2015
(51) Int. Cl.: G01R 33/30, B01F 3/04, G01R 33/46, G01R 33/28, A61K 49/18

(54) **CELLULE DE MESURE DE RMN ET ENSEMBLE DE MESURE DE RMN**
NMR-MESSZELLE UND NMR-MESSEINHEIT
NMR MEASUREMENT CELL AND NMR MEASUREMENT ASSEMBLY

(30) Priorité: 19.12.2014 FR 1462890
(43) Date de publication de la demande: 22.06.2016
(73) Titulaire: Commissariat à l'Énergie Atomique et aux Énergies Alternatives, 75015 Paris (FR)
(72) Inventeur: CAUSIER, Alexandre, 91190 GIF-SUR-YVETTE (FR); BERTHAULT, Patrick, 78114 MAGNY-LES-HAMEAUX (FR); BERTHELOT, Thomas, 91940 LES ULIS (FR); CARRET, Guillaume, 91140 VILLEBON-SUR-YVETTE (FR)
(74) Mandataire: Brevalex

(56) Documents cités:
- EP-A2- 1 901 782
- US-A1- 2011 285 396
- BOURNE ET AL: "A device for aeration and mixing of cell and organelle suspensions during nuclear magnetic resonance studies", ANALYTICAL BIOCHEMISTRY, ACADEMIC PRESS INC, NEW YORK, vol. 182, no. 1, 1 octobre 1989 (1989-10-01), pages 151-156, XP024821438, ISSN: 0003-2697, DOI: 10.1016/0003-2697(89)90733-1 [extrait le 1989-10-01]
- KARCZMAR G S ET AL: "A device for maintaining viable cells at high densities for NMR studies", JOURNAL OF MAGNETIC RESONANCE, ACADEMIC PRESS, LONDON, GB, vol. 53, no. 1, 1 juin 1983 (1983-06-01), pages 123-128, XP023961077, ISSN: 0022-2364, DOI: 10.1016/0022-2364(83)90080-X [extrait le 1983-06-01]
- ZACKARY I. CLEVELAND ET AL: "Continuously Infusing Hyperpolarized 129 Xe into Flowing Aqueous Solutions Using Hydrophobic Gas Exchange Membranes", THE JOURNAL OF PHYSICAL CHEMISTRY B, vol. 113, no. 37, 24 août 2009 (2009-08-24), pages 12489-12499, XP055205225, ISSN: 1520-6106, DOI: 10.1021/jp9049582
- SANKEY M ET AL: "SPRITE MRI of bubbly flow in a horizontal pipe", JOURNAL OF MAGNETIC RESONANCE, ACADEMIC PRESS, ORLANDO, FL, US, vol. 199, no. 2, 1 février 2009 (2009-02-01), pages 126-135, XP026252763, ISSN: 1090-7807, DOI: 10.1016/J.JMR.2009.01.034 [extrait le 2009-02-01]
- KAI RUPPERT: "Biomedical imaging with hyperpolarized noble gases", REPORTS ON PROGRESS IN PHYSICS, INSTITUTE OF PHYSICS PUBLISHING, BRISTOL, GB, vol. 77, no. 11, 31 octobre 2014 (2014-10-31), page 116701, XP020272060, ISSN: 0034-4885, DOI: 10.1088/0034-4885/77/11/116701 [extrait le 2014-10-31]

## Description

### DOMAINE TECHNIQUE

L'invention se rapporte au domaine de la spectroscopie par Résonance Magnétique Nucléaire, plus connue sous son sigle RMN, et de la possibilité de faire de la spectroscopie ou de l'imagerie sur une solution avec introduction de gaz.

### ÉTAT DE LA TECHNIQUE ANTÉRIEURE

De manière générale, les introductions de gaz dans les solutions pour les mesures de RMN sont faites en dehors de toute phase de mesure de RMN afin d'assurer une bonne dilution du gaz dans la solution et d'éviter que cette introduction perturbe les mesures par la présence de bulles qui pourrait créer des pertes d'homogénéité du champ magnétique. Cette introduction décalée vis-à-vis de la mesure est réalisée, par exemple, par agitation de la solution en présence de gaz et va généralement de pair avec une circulation de liquide pour assurer une bonne homogénéité de la solution. De plus, en raison des contraintes d'espace des spectromètres, l'introduction de gaz est faite par agitation « hors aimant » dans le champ de fuite de l'aimant du spectromètre RMN.

Il en résulte donc avec cette configuration usuelle, que si les cellules de mesure permettant une telle introduction de gaz sont compatibles avec les spectromètres RMN classiques, elles nécessitent néanmoins une circulation importante de solution pour permettre l'acheminement du gaz jusqu'au volume de détection du spectromètre, et donc une quantité de solution importante. Cela augmente donc, pour des solutions à mesurer coûteuses à obtenir, le coût d'une telle mesure. On notera de plus, qu'il est bien entendu difficile avec ce type d'introduction « hors aimant » et « hors période de mesure » d'utiliser des gaz présentant des propriétés magnétiques hors équilibre nécessitant le champ magnétique statique de l'aimant du spectromètre de RMN pour être maintenues.

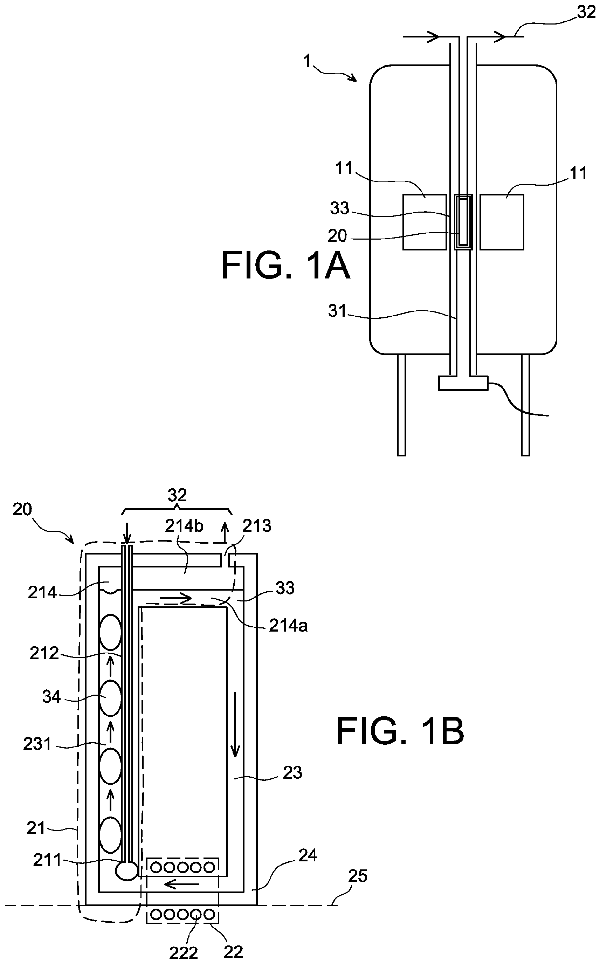

Afin de résoudre ce problème et ainsi permettre une mesure de RMN sur une solution avec introduction de gaz significative pendant la mesure et sous le champ magnétique statique du spectromètre de RMN, Cleveland Z.I. et ses collaborateurs ont développé une cellule de mesure adaptée. Cette cellule de mesure est décrite dans leur article publié dans le journal scientifique « Journal of physical chemistry B » vol 113 (27) pages 12489 à 12499 publié le 17 septembre 2009 et est notamment illustrée sur la figure 1 de cet article. Une telle cellule comporte dans le volume de détection de la cellule qui est placé dans le champ magnétique statique du spectromètre de RMN pendant la mesure :
- un module échangeur de gaz, similaire à celui décrit dans le document EP 1901782 B1,
- une chambre de mesure qui est soumise à un champ électromagnétique radiofréquence,
- un réseau de canalisations entre le module échangeur de gaz et la chambre de mesure.

Le module échangeur de gaz, afin de ne pas perturber la mesure de RMN, prend la forme d'un réseau de membranes délimitant des canaux de passage pour le gaz entre lesquelles circule la solution. Ces membranes sont partiellement étanches de manière à permettre un passage du gaz dans la solution sans que cette dernière puisse pénétrer les canaux de passage du gaz. La cellule comporte également, afin de permettre la circulation de la solution entre le module et la chambre de mesure, une extension du réseau de canalisations extérieure au volume de détection dans laquelle est prévu un système de pompage pour mettre en circulation la solution entre la chambre de mesure et le module échangeur de gaz.

Ainsi, si une telle cellule permet d'effectuer une mesure de RMN sur une solution avec introduction significative de gaz dans la solution sous champ magnétique statique du spectromètre de RMN, elle présente néanmoins certains inconvénients.

En effet, ce module échangeur de gaz, afin d'introduire une quantité significative de gaz dans la solution, présente des dimensions non compatibles avec les spectromètres RMN classiques. Ainsi, Cleveland Z.I. et ses collaborateurs ont dû effectuer la mesure de RMN au moyen d'un IRM destiné aux petits animaux dont le logement présente un diamètre de 10cm et peut donc accueillir des cellules de grande taille. Bien entendu, avec un tel IRM la résolution en fréquence est forcément dégradée vis-à-vis d'un spectromètre de RMN classique. On notera de plus, que la configuration choisie par Cleveland Z.I. et ses collaborateurs présente l'inconvénient d'être coûteuse en solution à analyser et en gaz, notamment en raison de l'utilisation d'un réservoir externe distant de 2,4m de la zone de mesure et d'une pompe péristaltique.

Pour les applications aux cellules biologiques qui nécessitent une alimentation en oxygène pendant la mesure, Bourne a également décrit dans le cadre de ces travaux publiés en 1989 dans la revue scientifique « Analycal Biochemistry » Vol. 182 pages 151-156, un dispositif d'aération à disposer dans une éprouvette à échantillon RMN. Un tel dispositif comporte un tube inférieur, noté « draft tube » délimitant la zone de mesure qui sera soumise à la bobine réceptrice lors de la mesure RMN et un corps de dispositif dans lequel est ménagée une canalisation en communication fluidique avec le tube inférieur. Ladite canalisation comporte une zone d'introduction de gaz dans laquelle est aménagée une entrée de gaz pour générer des bulles uniquement dans la zone d'introduction de gaz.

Si un tel dispositif permet une introduction de gaz dans la solution avec un risque de présence de bulles dans la zone de mesure qui est particulièrement faible, il ne permet pas d'obtenir une introduction de gaz pleinement efficace et semble peu compatible avec un système de circulation de liquide. En effet, l'introduction de gaz n'a lieu que par diffusion du gaz à partir de la zone d'introduction jusqu'à la zone de mesure et cette diffusion reste contenue ceci notamment en raison d'une canalisation de diamètre réduit mettant ces deux zones en communication. De plus, avec un tel dispositif, la circulation de liquide devra se faire par les canalisations latérales (notées « side channel »), donc à l'extérieur de l'éprouvette, et le peu de gaz introduit au moyen de la zone d'introduction sera alors évacué par la circulation de solution. Ainsi, le dispositif proposé par Bourne semble peu efficace et ne semble pas approprié dans le cas où une circulation de la solution dans le champ statique magnétique statique du spectromètre de RMN serait recherchée notamment pour obtenir une solution homogène, notamment en dilution du gaz dans la solution.

### EXPOSÉ DE L'INVENTION

L'invention vise à remédier au moins partiellement à ces inconvénients et a ainsi notamment pour but de fournir une cellule permettant une mesure de RMN en solution qui, tout en autorisant une introduction de gaz significative dans le volume de détection de la cellule sans perturbation de la mesure, puisse offrir une circulation de la solution sans perturbation de l'introduction de gaz tout ceci en présentant un encombrement réduit afin d'être adaptée pour être utilisée avec des spectromètres classiques dont la zone de détection présente généralement un diamètre inférieur à 2cm.

L'invention a également pour but de fournir une cellule RMN autorisant une circulation de fluide uniquement dans la cellule de mesure ceci sans l'utilisation d'élément mécanique et/ou électromagnétique qui pourrait perturber le champ magnétique statique du spectromètre de RMN.

L'invention concerne à cet effet une Cellule de mesure de Résonance Magnétique Nucléaire, ou RMN, en solution autorisant l'introduction d'un gaz dans ladite solution, la cellule de mesure étant destinée à être placé dans un champ magnétique statique tel que celui d'un spectromètre de RMN, et comprenant:
- au moins une chambre de mesure de la solution dans laquelle un champ électromagnétique radiofréquence est destiné à être appliqué et/ou à être mesuré,
- au moins une canalisation pour la solution en communication fluidique avec la chambre de mesure, ladite canalisation comportant une zone d'introduction de gaz comprenant une entrée de gaz pour générer des bulles uniquement dans la zone d'introduction des gaz,
la cellule de mesure comportant en outre :
- un réseau de canalisations incluant l'au moins une canalisation et formant un circuit fermé de circulation de la solution entre la chambre de mesure et la zone d'introduction de gaz, l'entrée des gaz étant agencée de manière à entrainer une circulation de la solution dans le réseau de canalisations entre la zone d'introduction de gaz et la chambre de mesure, la chambre de mesure comprend une canalisation du réseau de canalisations, dite de mesure,
- un système radiofréquence agencé pour appliquer et/ou détecter un champ électromagnétique radiofréquence dans la canalisation de mesure.

Une telle cellule de mesure permet, en raison d'une introduction de gaz au moyen de bulles de gaz générées directement dans le réseau de canalisations, une introduction de gaz efficace sans nécessiter un module échangeur de gaz de grande dimension contrairement à la cellule développée par Cleveland Z.I. et ses collaborateurs. Il en résulte qu'une cellule de mesure selon l'invention peut présenter des dimensions contenues compatibles avec les cavités des spectromètres classiques, c'est-à-dire présentant un diamètre inférieur à 2 cm. De plus la génération de bulles ayant lieu dans une partie du réseau de canalisations distincte de la chambre de mesure, les mesures de RMN ne sont pas perturbées par l'introduction de gaz.

De plus, un réseau de canalisations formant un circuit fermé de circulation de la solution permet, par une simple introduction de gaz, d'obtenir mise en circulation de la solution dans le réseau de canalisations entre la zone d'introduction de gaz et la chambre de mesure. Il n'est donc pas nécessaire de prévoir un système de pompage de la solution pour la mettre en circulation dans la cellule et obtenir son homogénéisation. De cette manière, une telle cellule peut donc, dans un volume réduit compatible avec des spectromètres classiques, comporter l'ensemble du système de circulation de la solution avec une introduction efficace de gaz en solution et une mise en circulation assurant une dissolution du gaz homogène dans toute la solution et notamment au niveau de la chambre de mesure. Une telle cellule permet donc de faire des mesures RMN en solution avec une introduction de gaz efficace qui sont parfaitement résolues et stables dans le temps, tout en étant compatible avec une introduction de gaz présentant des propriétés magnétiques hors équilibre, ceci avec un spectromètre RMN classique.

Une telle cellule est donc également particulièrement avantageuse lorsqu'il est recherché une circulation de la solution afin d'éviter une éventuelle stagnation de la solution dans chambre de mesure qui serait préjudiciable à la mesure RMN, ceci sans nécessiter une quantité de solution importante comme c'est le cas dans l'art antérieur nécessitant une circulation et un système de pompage externes à la cellule de mesure.

On entend ci-dessus et dans le reste de ce document par mesure d'un champ électromagnétique radiofréquence les mesures de signaux électromagnétiques radiofréquences quels qu'ils soient y compris des perturbations électromagnétiques générées par le bruit de spin.

Par cellule de mesure de Résonance Magnétique Nucléaire en solution, il faut bien entendu comprendre cellule, ou cuve, permettant d'effectuer une mesure par RMN en solution, c'est-à-dire milieu liquide, pour caractériser l'ensemble des espèces présentes dans ladite solution.

On entend ci-dessus et dans le reste de ce document par « circuit fermé de la solution» que le réseau de canalisations ne comporte pas, dans les conditions de mesure, d'entrée ou de sortie pour la solution, la solution circulant ainsi en circuit fermé. On notera que cela n'exclut bien entendu pas la possibilité selon laquelle le réseau de canalisations comporte plusieurs branches de circulation en parallèle et/ou en série, celles-ci étant incluses dans le volume de détection.

La zone d'introduction de gaz peut comporter en outre une sortie de gaz en communication fluidique avec le réseau de canalisations qui est destinée à être hors solution.

Avec une telle sortie de gaz, les bulles émergent hors solution avant que le gaz ainsi libéré puisse être évacué par la sortie de gaz ce trouvant hors solution. On évite ainsi tout risque de présence de bulle de gaz dans la chambre de mesure qui pourrait perturber la mesure RMN.

La chambre de mesure peut être configurée de manière à ce que le rapport de distances de circulation de la solution dans le réseau de canalisations de la chambre de mesure de la distance de circulation de la chambre de mesure vers l'entrée de gaz sur la distance de circulation de la sortie de gaz vers la chambre de mesure est inférieur à 1, celui-ci étant préférentiellement inférieur à 0,5 et encore plus préférentiellement inférieur à 0,2.

On entend ci-dessus et dans le reste de ce document par « distance de circulation de solution » entre deux parties de la cellule de mesure reliées entre elle par le réseau de circulation la longueur de canalisation reliant lesdites parties.

Avec un tel rapport de distances de circulation, la chambre de mesure se trouve à une distance relativement importante de la zone d'introduction de gaz dans le sens de circulation de solution. On limite ainsi les risques de présence de bulles en solution non dissoutes au niveau de la chambre de mesure et donc les perturbations de mesure qui en résulteraient.

La cellule de mesure peut comporter une embase pour son installation dans un spectromètre de RMN définissant un plan d'appui, et la zone d'introduction de gaz pouvant comporter une canalisation du réseau de canalisations, dite d'introduction de gaz, qui s'étend transversalement, voire sensiblement perpendiculairement, au plan d'appui, l'entrée de gaz se trouvant dans la canalisation d'introduction de gaz proche de l'embase par rapport à la sortie des gaz.

Avec une introduction de gaz au niveau de l'embase dans un conduit de transversal, préférentiellement perpendiculaire, au plan d'appui, les bulles bénéficient pleinement de la poussée d'Archimède lors de leur trajet de l'entrée vers la sortie des gaz. Leur vitesse de déplacement ainsi augmentée par la poussée d'Archimède se répercute sur la mise en circulation. On obtient donc avec une telle cellule une circulation continue de la solution dans le réseau de circulation efficace.

La cellule de mesure peut comporter un conduit d'amenée de gaz disposé dans la canalisation d'introduction de gaz dont une première extrémité débouche dans la canalisation d'introduction de gaz et forme l'entrée de gaz.

Avec un tel conduit, la cellule peut comporter l'ensemble de ses branchements à un réseau d'alimentation en gaz qui soit sur le sommet de la cellule. Le branchement de la cellule s'en trouve donc facilité.

La canalisation d'introduction des gaz peut déboucher dans une aire d'extraction de gaz dont une première partie délimite une canalisation du réseau de canalisations et une seconde partie est destinée à être hors solution, la sortie de gaz étant disposée dans ladite seconde partie.

La cellule de mesure peut comprendre un système radiofréquence agencé dans la zone de mesure pour appliquer et/ou détecter un champ électromagnétique radiofréquence dans la chambre de mesure.

La cellule de mesure peut comporter un corps réalisé en deux portions, une première portion formant embase pour l'installation de la cellule de mesure dans un spectromètre de RMN et dans laquelle est ménagée la chambre de mesure, et une deuxième portion comportant la zone d'introduction des gaz, lesdites première et deuxième portions étant complémentaires en forme de manière à ce que le réseau de canalisations soit formé par l'assemblage de la première et la deuxième portion.

La première portion peut comporter un premier et un deuxième élément, le premier élément formant l'enveloppe extérieure de la première portion, le deuxième élément comportant la chambre de mesure et le système radiofréquence.

Une telle conception de la cellule permet d'adapter le matériau de chaque partie de la cellule afin de répondre aux contraintes des mesures RMN ceci sans augmentation drastique du coût de fabrication de la cellule. Ainsi par exemple, il est possible de prévoir un deuxième élément de la première portion en verre, afin de limiter les risques de perturbation de la mesure RMN, le premier élément de la première portion et la deuxième portion pouvant être réalisés dans un plastique plus simple à utiliser et moins coûteux.

La cellule de mesure peut être dimensionnée pour être placée dans un champ magnétique statique tel que celui d'un spectromètre de RMN, l'ensemble de la cellule de mesure forme ainsi le volume de détection.

Une telle configuration facilite le montage de la cellule dans un spectromètre RMN.

La cellule de mesure peut comprendre en outre dans la zone d'introduction de gaz un système de filtration agencé dans le réseau de canalisations pour intercepter les bulles de gaz en sortie de la zone d'introduction de gaz dans la direction de circulation de la solution.

Le système de filtration peut comprendre une grille de filtration dont la maille est inférieure à 1 mm voire à 0,5 mm.

De tels systèmes de filtration autorisent une introduction de gaz dans la solution plus importante et donc des vitesses de circulation dans le réseau de canalisations également plus importantes sans risque que ces introduction et vitesse plus importantes entrainent un risque accru de présence de bulle dans la chambre de mesure. De même, on évite les risques de présence de bulles en dehors de la zone d'introduction qui pourrait entraîner un bouchage des canalisations du réseau de canalisations en dehors de cette zone. Il est donc possible de prévoir des diamètres de canalisation relativement faible pour ces canalisations en dehors de la zone d'introduction et donc de réduire d'autant la quantité de solution nécessaire pour la cellule de mesure selon l'invention.

La cellule de mesure peut comporter :
- une embase pour son installation dans un spectromètre de RMN définissant un plan d'appui,
- au moins deux canalisations, une première canalisation dite d'introduction de gaz, et une deuxième canalisation qui s'étendent toutes deux transversalement, voire sensiblement perpendiculairement, au plan d'appui, la canalisation d'introduction de gaz comportant une entrée des gaz afin de former des bulles dans la première canalisation et ainsi former la zone d'introduction de gaz,
- au moins une troisième et une quatrième canalisations reliant la première et la deuxième canalisations au niveau de leurs extrémités se trouvant respectivement à proximité de l'embase et à distance de l'embase, ceci de manière à former un circuit fermé de circulation de la solution et a ainsi former le réseau de canalisations,
- le système radiofréquence agencé dans la zone de mesure pour appliquer et/ou détecter un champ électromagnétique radiofréquence dans une portion de la troisième canalisation de manière à définir une chambre de mesure.

L'invention concerne un procédé de fabrication d'une cellule de mesure comportant les étapes consistant à :
- fournir un système radiofréquence,
- fournir une canalisation dite de mesure pour former la canalisation de mesure,
- agencer le système radiofréquence vis-à-vis de la canalisation de mesure de manière à ce le système radiofréquence soit agencé pour appliquer et/ou détecter un champ électromagnétique radiofréquence dans la canalisation de mesure (23) de manière à former une chambre de mesure,
- fournir des canalisations supplémentaires pour former un réseau de canalisations avec la canalisation de mesure, ledit réseau de canalisations incluant une canalisation pour la solution en communication fluidique avec la chambre de mesure, ladite canalisation comportant une zone d'introduction de gaz comprenant une entrée de gaz pour générer des bulles uniquement dans la zone d'introduction des gaz, réseau de canalisations formant un circuit fermé de circulation de la solution entre la chambre de mesure et la zone d'introduction de gaz, l'entrée des gaz étant agencée de manière à entrainer une circulation de la solution dans le réseau de canalisations entre la zone d'introduction de gaz et la chambre de mesure,
- former la cellule de mesure en assemblant les canalisations supplémentaires avec l'ensemble formé lors de l'agencement du système radiofréquence vis-à-vis de la canalisation de mesure.

Un tel procédé de fabrication permet la fourniture d'une cellule selon l'invention.

L'étape de fourniture des canalisations supplémentaires pour former un réseau de canalisations avec la canalisation de mesure, peut consister à fournir le réseau de canalisations, une canalisation incluse dans la chambre de mesure exclue, l'entrée de gaz étant aménagée dans ledit réseau de canalisations, lesdites canalisations supplémentaires formant un premier élément,
l'étape d'agencement du système radiofréquence vis-à-vis de la canalisation de mesure de manière à ce le système radiofréquence de la chambre de mesure consistant à former un deuxième élément comportant la canalisation incluse dans la chambre de mesure et un système radiofréquence apte à générer et/ou à mesurer un champ radiofréquence,
l'étape de formation de la cellule de mesure consistant à assembler le réseau de canalisations, la canalisation incluse dans la chambre de mesure exclue, avec le deuxième élément comportant la canalisation incluse dans la chambre de mesure.

En variante, l'invention concerne également un procédé de fabrication d'une cellule de mesure comportant les étapes consistant à :
- fournir une zone d'introduction de gaz comportant une entrée de gaz dans une canalisation,
- fournir au moins une chambre de mesure de la solution dans laquelle un champ électromagnétique radiofréquence est destiné à être appliqué et/ou à être mesuré,
- former un réseau de canalisations pour la solution agencé pour mettre en communication fluidique la chambre de mesure avec la zone d'introduction de gaz, ledit réseau de canalisations comportant la canalisation dans laquelle se trouve l'entrée de gaz.

Un tel procédé de fabrication permet la fourniture d'une cellule selon l'invention.

L'étape de fourniture de la zone d'introduction de gaz peut consister à fournir le réseau de canalisations, une canalisation incluse dans la chambre de mesure exclue, l'entrée de gaz étant aménagée dans ledit réseau de canalisations.

L'étape de fourniture de la chambre de mesure peut consister à fournir un deuxième élément comportant la canalisation incluse dans la chambre de mesure et un système radiofréquence apte à générer et/ou à mesurer un champ radiofréquence.

L'étape de formation du réseau de canalisations peut consister à assembler le réseau de canalisations, la canalisation incluse dans la chambre de mesure exclue, avec le deuxième élément comportant la canalisation incluse dans la chambre de mesure.

Avec de telles étapes de fourniture ou de formation de la zone d'introduction de gaz, de la chambre de mesure et du réseau de canalisations, il est possible de former une cellule avec des matériaux différents, tel que du verre ou du quartz pour la chambre de mesure et un plastique pour le reste de la cellule. Il est ainsi envisageable de réduire le coût de fabrication d'une telle cellule tout en respectant les contraintes de matériau imposées pour la chambre de mesure pour les mesures RMN.

L'invention concerne également un ensemble de mesure par Résonance Magnétique Nucléaire, ou RMN, en solution comportant :
- un spectromètre de RMN, ou équivalent, adapté pour générer un premier champ magnétique statique, et
- une cellule de mesure de RMN en solution,
- un système d'introduction du gaz,
la cellule de mesure étant une cellule selon l'invention présentant son entrée de gaz connectée au système d'introduction de gaz.

Un tel ensemble comportant une cellule selon l'invention présente les avantages inhérents à cette cellule qui ont été décrits plus haut.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- les figures 1A et 1B illustrent deux vues schématiques de respectivement un spectromètre de RMN équipé d'une cellule de mesure selon l'invention et d'une cellule de mesure selon l'invention,
- les figures 2A et 2B illustrent deux mesures de RMN réalisées sur une solution de cryptophanes dans laquelle est introduit un gaz de Xénon hyperpolarisé, l'introduction étant réalisée pour les spectres des figures 2A et 2B respectivement par agitation selon un procédé de l'art antérieur et par formation de bulles au moyen d'une cellule de mesure telle que schématisée à la figure 1B,
- la figure 3 illustre graphiquement les résultats obtenus lors d'une application de l'invention pour lesquels c'est la possibilité de mise en circulation de la solution dans la cellule qui est recherchée,
- les figures 4A et 4B illustrent respectivement une vue en coupe et de trois-quarts avec pour cette dernière certains éléments représentés en transparence,
- les figures 5A et 5B illustrent respectivement une cellule RMN selon un deuxième mode de réalisation adaptée pour permettre une vitesse importante de circulation de la solution, la figure 5A illustrant une vue en coupe transversale de la partie supérieure de ladite cellule RMN et la figure 5B illustrant une vue de trois-quarts de cette même cellule RMN.

Des parties identiques, similaires ou équivalentes des différentes figures portent les mêmes références numériques de façon à faciliter le passage d'une figure à l'autre.

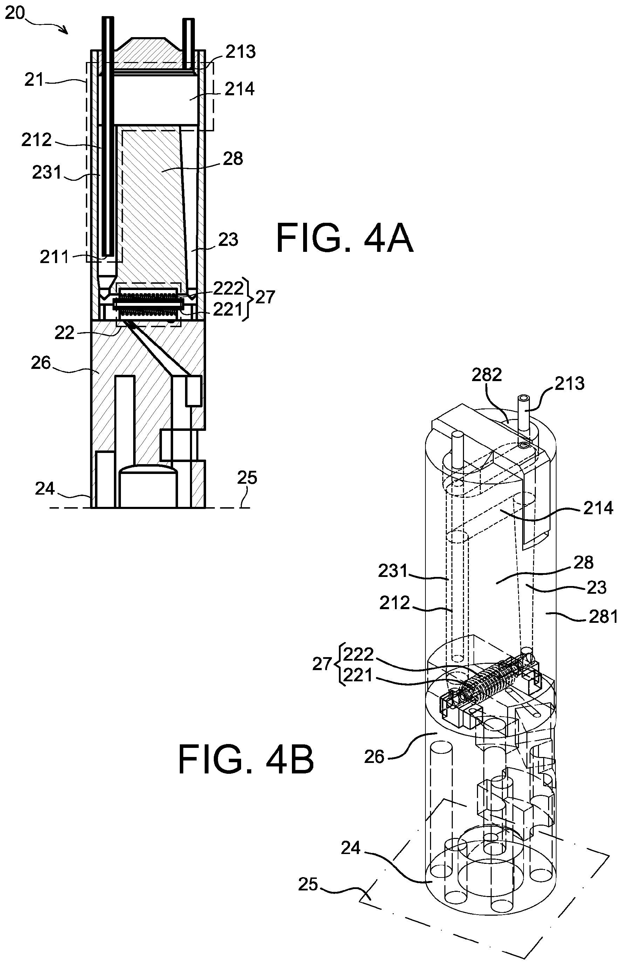

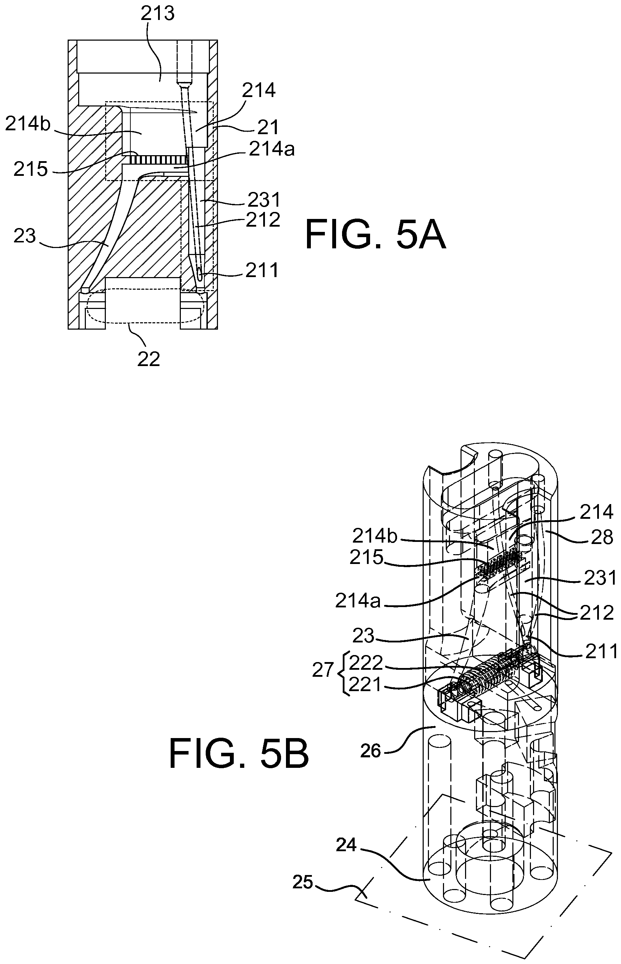

Les différentes parties représentées sur les figures 1A et 1B ne le sont pas nécessairement selon une échelle uniforme, pour rendre les figures plus lisibles. Les figures 4A et 4B, ainsi que les figures 5A et 5B, ont été réalisées à l'échelle.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 1A illustre un exemple d'ensemble de mesure par RMN comprenant un aimant de RMN 1 standard et une cellule de mesure 20 selon l'invention dans laquelle a été introduit une solution 33 à analyser, ladite cellule de mesure 20 étant disposée de manière être soumise au champ magnétique statique de l'aimant de RMN. Le champ magnétique statique 20, sur la figure 1A, est figuré par le système de bobine 11 permettant de le générer.

Dans la configuration illustrée sur la figure 1, la cellule de mesure 20 étant disposée de manière à être soumise sur tout son volume au champ magnétique statique de l'aimant de RMN, la cellule dans son intégralité forme un volume de détection placé dans le champ magnétique statique de l'aimant de RMN 1.

La cellule de mesure 20, illustrée sur la figure 1B, comporte :
- une zone d'introduction de gaz 21 dans la solution 33 dans laquelle se trouve une entrée de gaz 211 et une sortie de gaz 213 ceci de manière à permettre la génération de bulles 34 de gaz uniquement dans la zone d'introduction de gaz,
- au moins une chambre de mesure 22 de la solution 33 dans laquelle un champ électromagnétique radiofréquence est appliqué et/ou mesuré pendant la mesure de RMN, la chambre de mesure 22 étant à distance de la zone d'introduction de gaz 21,
- un réseau de canalisations 23 pour la solution 33 agencé pour mettre en communication fluidique la chambre de mesure 22 avec la zone d'introduction de gaz 20,
- une embase 24 par laquelle la cellule de mesure est en appui dans un logement du spectromètre de RMN, ladite embase délimitant un plan d'appui de la cellule dans ledit logement.

On peut voir plus précisément sur la figure 1B que la zone d'introduction de gaz 21 comporte une canalisation 231 du réseau de canalisations 23, dite canalisation d'introduction de gaz. La canalisation d'introduction de gaz 231 s'étend sensiblement perpendiculairement au plan d'appui 25 avec l'entrée de gaz 211 se trouvant dans la canalisation d'introduction de gaz 231 proche de l'embase 24 par rapport à la sortie des gaz 213. On peut ainsi voir, sur la figure 1B que l'entrée des gaz 211 se trouve dans la partie basse de la canalisation d'introduction de gaz 231.

Selon une variante de l'invention, non illustrée, la canalisation d'introduction de gaz 231 peut également s'étendre sensiblement transversalement par rapport au plan d'appui 25. Ainsi, s'il est préférable que la canalisation d'introduction de gaz 231 s'étende selon une direction présentant une pente significative par rapport au plan d'appui, ladite pente peut néanmoins être comprise entre 10 et 90° sans que l'on sorte du cadre de l'invention.

Afin de fournir l'entrée de gaz 211 dans la canalisation d'introduction de gaz 231, la cellule de mesure 20 comporte également dans la zone d'introduction de gaz 21 un conduit d'amenée de gaz 212 qui est disposé dans la canalisation de gaz 231 avec une première extrémité qui débouche dans la canalisation de gaz 231. L'ouverture de la première extrémité du conduit d'amenée de gaz 212 forme ainsi l'entrée de gaz 211. La deuxième extrémité du conduit d'introduction de gaz 212 communique avec l'extérieur de la cellule d'amenée 20 de manière à permettre la connexion du conduit d'amenée de gaz 212 à un réseau d'alimentation en gaz 32 tel qu'un réseau d'alimentation en xénon hyperpolarisé ou de l'hélium 3. Un tel réseau d'alimentation en gaz 32 forme un système d'introduction de gaz.

Afin de contrebalancer les pertes de charge induites par un petit diamètre, et l'occupation en volume du conduit d'amené de gaz 21, le diamètre du conduit d'amenée de gaz 21 présente un diamètre proche de celui de la canalisation d'introduction de gaz 231. Typiquement, le conduit d'amené de 21 peut présenter un diamètre extérieur entre 1,2 fois et 1.5 fois inférieur au diamètre intérieur de la canalisation d'introduction de gaz231.

Afin d'extraire le gaz introduit par l'entrée de gaz 211, la cellule de mesure 20 comporte en outre dans la zone d'introduction de gaz 21 une aire d'extraction 214 de gaz dont une première partie 214a délimite une canalisation du réseau de canalisations 23 et une seconde partie 214b est hors solution. La sortie de gaz 213 est disposée dans ladite seconde partie 214b en étant ainsi mise en communication fluidique avec le réseau de canalisations 23 par l'aire d'extraction 214.

L'aire d'extraction 214, et donc la zone de d'introduction de gaz 21, sont mises en communication fluidique avec la chambre de mesure 23 par le réseau de canalisations 23 de manière à ce que la chambre de mesure 22 puisse être alimentée en gaz par l'introduction de gaz dans la zone d'introduction de gaz 231.

Comme illustré sur la figure 1B, la chambre de mesure 22 peut être formée par une canalisation du circuit de canalisations 23 ceci en prévoyant dans la cellule de mesure 20 un moyen adapté pour générer et/ou mesurer au niveau de ladite canalisation un champ électromagnétique radiofréquence. Un tel moyen de génération et/ou de mesure d'un champ électromagnétique peut être fourni par un système de bobine 222, tel qu'un solénoïde, une bobine en selle de cheval, une bobine de Helmholtz, une bobine en cage d'oiseau, adapté tel qu'illustré sur la figure 1B. Plus généralement un tel moyen est dénommé système radiofréquence.

La chambre de mesure est agencée de manière à ce que le rapport de distances de circulation de la solution 33 dans le circuit de canalisations de la chambre de mesure vers l'entrée de gaz 211 et de la sortie de gaz 213 vers la chambre de mesure 23 est inférieure à 1, celui-ci étant préférentiellement inférieur à 0,5 et encore plus préférentiellement inférieur à 0,2. Ainsi dans la configuration illustrée sur la figure 1B, ce rapport est d'environ un septième.

La mise en communication de la zone d'introduction de gaz 21 avec la chambre de mesure 22 par le réseau de canalisations 23 est faite de manière à ce que le réseau de canalisation forme un circuit fermé pour la circulation de la solution 33.

Ainsi avec une telle configuration de cellule de mesure 20, lorsque du gaz est introduit par l'entrée de gaz 211, il forme des bulles 34 dans la canalisation d'introduction de gaz 231 qui émergent au niveau de l'aire d'extraction 214 dans sa deuxième partie 214b. Cette émersion des bulles 34 dans la deuxième partie 214b de l'aire d'extraction 214 introduit du gaz qui est récupéré par la sortie de gaz 213. Il en résulte donc que les bulles 34 sont générées et transitent uniquement dans la canalisation d'introduction de gaz 231 et la première partie de l'aire d'extraction 214, aucune bulle 34 n'étant générée dans le reste du réseau de canalisations 23. On obtient par la mise en contact des bulles 34 de gaz avec la solution 33 dans la canalisation d'introduction 231 une bonne dissolution de gaz dans la solution 33 sans que cette introduction de gaz dans la solution 33 ne vienne perturber la chambre de mesure 22.

Le déplacement de chaque bulle dans la zone d'introduction de gaz 21 engendre une dépression dans la canalisation d'introduction de gaz 231 qui permet de mettre en déplacement la solution 33 dans le réseau de canalisation 23. Ainsi, l'injection de gaz dans la zone d'introduction de gaz 21 permet une mise en circulation de la solution 33 dans le réseau de canalisations 23 entre la zone d'introduction de gaz 21 et la chambre de mesure 22.

Une telle cellule de mesure 20 permet donc dans le volume réduit du logement d'un spectromètre de RMN classique d'obtenir à la fois une dissolution de gaz en solution dans le champ magnétique statique du spectromètre de RMN et une mise en mouvement de la solution 33 ceci sans que la mesure de RMN dans la chambre de mesure 20 ne soit perturbée.

On notera qu'en alternative et de manière complémentaire à la description faite ci-dessus de la cellule de mesure selon l'invention, la cellule de mesure 20 selon l'invention comporte :
- l'embase 24 pour son installation dans un spectromètre de RMN 1 définissant un plan d'appui 25,
- au moins deux canalisations, une première canalisation 231 dite d'introduction de gaz, et une deuxième canalisation 232 qui s'étendent toutes deux transversalement, voire sensiblement perpendiculairement, au plan d'appui 25, la canalisation d'introduction de gaz 231 comportant une entrée des gaz afin de former des bulles dans la première canalisation et ainsi former la zone d'introduction de gaz,
- au moins une troisième et une quatrième canalisation 233, 234 reliant la première et la deuxième canalisation au niveau de leurs extrémités se trouvant respectivement à proximité de l'embase et à distance de l'embase, ceci de manière à former un circuit fermé de circulation de la solution et a ainsi former le réseau de canalisations,
- le système radiofréquence 222 agencé dans la zone de mesure pour appliquer et/ou détecter un champ électromagnétique radiofréquence dans une portion de la troisième canalisation de manière à définir la chambre de mesure 22.

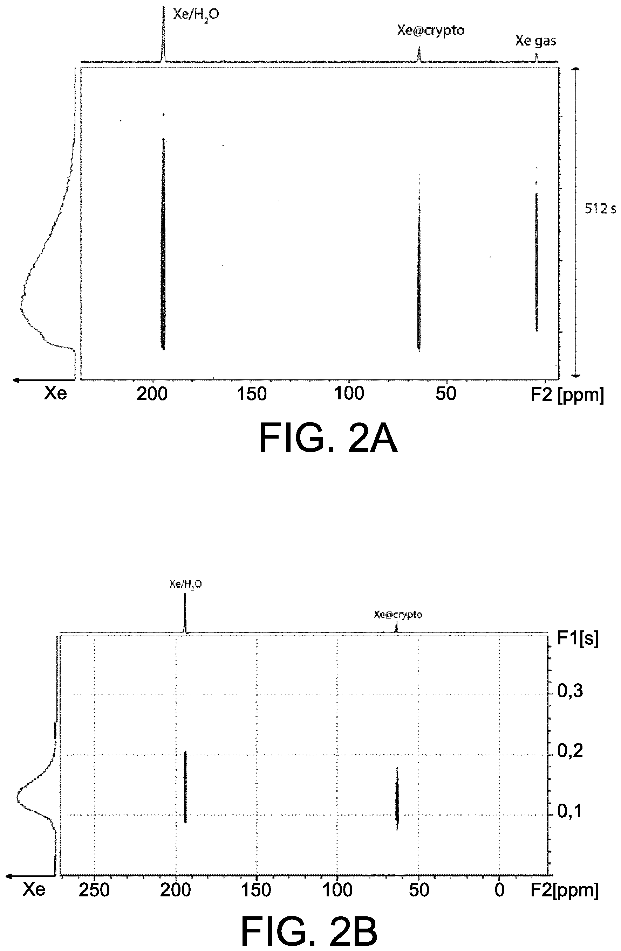

Les figures 2A et 2B illustrent les mesures de RMN correspondant à deux mesures réalisées sur une solution de cryptophanes pendant l'introduction de xénon hyperpolarisé. Chacune de ces mesures montrent la variation du signal RMN avec la quantité de xénon hyperpolarisé, l'évolution de la quantité de xénon hyperpolarisé étant représentée graphiquement sur la partie gauche des figures. Les différents pics RMN détectés pendant ces mesures sont reproduits sur la partie haute de ces figures.

Lors des mesures reproduites sur la figure 2A, l'introduction de gaz est réalisée selon un procédé de l'art antérieur qui consiste à dissoudre le xénon hyperpolarisé dans la solution 33 par agitation. On peut remarquer sur ce premier spectre que les pics de xénon dissous (Xe/H2O) et encapsulé dans les cryptophanes (Xe@crypto) sont accompagnés d'un pic de xénon sous forme gazeux (Xegaz) démontrant ainsi que la dissolution n'est que partielle. La mesure de RMN avec ce procédé de l'art antérieur est donc perturbée par l'introduction du xénon hyperpolarisé pendant la mesure. Concernant la figure 2B, l'introduction du xénon hyperpolarisé est réalisée au moyen d'une cellule selon le principe de l'invention. On peut voir qu'avec l'utilisation d'une cellule de mesure 20 selon l'invention, si l'on observe également les pics de xénon dissous (Xe/H2O) et réagissant avec les cryptophanes (Xe@crypto), aucun pic de xénon gazeux n'est observé. Cela montre qu'une cellule de mesure 20 permet d'obtenir une introduction de gaz efficace sans que cette dernière introduction ne perturbe la mesure de RMN.

Une telle cellule de mesure 20 peut donc être installée dans un spectromètre de RMN selon la configuration illustrée sur la figure 1A. Dans cette configuration, après introduction de la solution 33 à mesurer dans la cellule de mesure 20, cette dernière est mise en place dans le logement correspondant avec son embase en appui dans la partie de basse dudit logement. Le conduit d'amenée de gaz et la sortie de gaz sont tous deux branchés à un réseau d'alimentation en gaz et le système radiofréquence est branché au spectromètre de RMN de manière à permettre la génération et/ou la mesure d'un champ électromagnétique radiofréquence dans la chambre de mesure à ce dernier.

Le spectromètre de RMN et la solution forme ainsi un ensemble de mesure par Résonance Magnétique Nucléaire.

On peut noter qu'un tel ensemble est particulièrement adapté pour une mesure d'une solution avec introduction d'un gaz présentant des propriétés magnétiques hors équilibre, tel qu'un gaz de xénon ou d'hélium 3 hyperpolarisés, et qui nécessite le champ magnétique statique du spectromètre de RMN pour prolonger la durée de vie de cet état. Néanmoins, son application ne se limite pas à ce seul type de mesure. En effet, la cellule de mesure 20 est parfaitement adaptée pour permettre l'introduction de tout type de gaz lors d'une mesure de RMN quel que soit le but de cette introduction. Une telle cellule peut ainsi être mise en œuvre pour des mesures dans lesquelles :
- le gaz sert à alimenter la solution, par exemple de l'oxygène dans une solution biologique,
- le gaz interagit avec la solution, on peut par exemple citer la polarisation ci-dessus,
- le gaz sert de vecteur à un additif à apporter à la solution,
- le gaz constitue lui-même l'objet de la mesure.

Selon ces autres possibilités d'application, la cellule de mesure 20 présente entre autre avantage supplémentaire à la possibilité d'introduction de gaz sans perturbation de la mesure de RMN de réduire la quantité de solution 33 nécessaire pour la mesure de RMN puisqu'un réseau de canalisation hors volume de détection n'est pas nécessaire.

Une autre application de la cellule de mesure 20 selon l'invention est l'utilisation de l'introduction de gaz pour uniquement fournir une circulation de la solution dans la cellule en elle-même. Selon cette possibilité, ce qui est recherché, c'est la fourniture d'une circulation de solution dans le réseau de canalisations et donc de circulation de la solution dans la chambre de mesure pour éviter toute stagnation de la solution dans la chambre de mesure..

Ainsi, la cellule de mesure 20 peut également être mise en œuvre dans le cadre de l'étude d'atomes en phase liquide dont les noyaux relaxent lentement. Ce type d'étude concerne de nombreux isotopes et composés parmi lesquels on peut citer :
- les molécules organiques comportant des atomes de carbone ou d'azote non couplés à des atomes d'hydrogène,
- les noyaux qui ne possèdent pas de mécanisme de relaxation intrinsèque très efficace (telle que le serait la relaxation quadripolaire par exemple), et
- les noyaux pour lesquels la relaxation longitudinale est longue alors que la relaxation transversale est courte (cas des atomes dans des grosses molécules ou assemblages moléculaires, pour lesquelles le temps de réorientation dans le champ est grand).

En effet, dans la cellule de mesure 20 selon l'invention seuls les atomes présents dans la zone de mesure sont excités par la radiofréquence et sont détectés. Or, lors de telles mesures, il est nécessaire d'attendre leur relaxation pour les détecter à nouveau. Ainsi, la circulation de l'invention permet de renouveler en continu les atomes présents dans la zone de mesure en remplaçant les atomes excités par des atomes qui se sont désexcités pendant leur circulation dans le réseau de canalisations. On accélère ainsi grandement le rythme des séquences, par la diminution drastique du temps de répétition entre deux mesures RMN qui devient dès lors indépendant du temps de relaxation des noyaux.

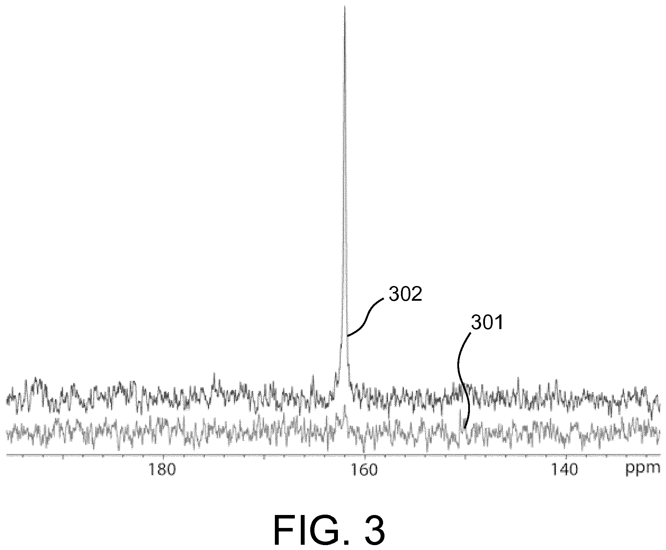

La figure 3 illustre ainsi cette possibilité lors d'une mesure effectuée sur une solution d'urée dont 99% des molécules comportent l'isotope 13 du carbone à la concentration de 200 mmol.L⁻¹ dans de l'eau. La figure 3 illustre ainsi le signal RMN mesuré sans circulation 301 et avec une circulation 302 dans le réseau de canalisations obtenue par une introduction d'un débit gaz de 1 ml.min⁻¹. Les conditions expérimentales lors de ces deux mesures sont identiques et les suivantes :
- champ magnétique statique de 11.74 Tesla,
- système de bobine 222 accordée à 125.76 MHz,
- 16 mesures RMN acquises, précédés de 2 mesures sans acquisition,
- temps de répétition entre deux mesures RMN de 2 secondes.

On peut ainsi voir qu'en l'absence de circulation de la solution le graphique montre sous la référence 301 que le signal est du même ordre de grandeur que le bruit de fond tandis que la mise en circulation du fluide permet de récupérer un pic correspondant à l'isotope 13 du carbone avec une intensité accrue vis-à-vis de celle sans circulation de fluide. Le rapport signal sur bruit se trouve donc grandement amélioré vis-à-vis d'une mesure dans laquelle la solution est statique.

Les figures 4A et 4B illustrent une vue en coupe et en perspective d'une cellule de mesure 20 selon une première conception pratique du principe de l'invention illustré sur la figure 1A.

La cellule de mesure 20 illustrée sur les figures 4A et 4B comporte un corps réalisé en deux portions 26, 27, 28 , une première portion 26, 27 formant l'embase pour l'installation de la cellule de mesure 20 dans le logement du spectromètre de RMN et dans laquelle est ménagée la chambre de mesure 21, et une deuxième portion 29 comportant la zone d'introduction de gaz , lesdites première et deuxième portions étant complémentaires en forme, de manière à ce que le réseau de canalisations 23 soit formé par l'assemblage de la première et la deuxième portion 26, 27, 28. La première portion 26, 27 comporte un premier et un deuxième élément 26, 27, le premier élément 26 formant l'enveloppe extérieure de la première portion 26, 27, le deuxième élément 37 comportant la chambre de mesure 22.

Ainsi, on peut voir sur les figures 4A et 4B, que la cellule de mesure présente une forme générale cylindrique, la première portion 26, 27 représentant la partie inférieure et la deuxième portion 28 représentant la partie supérieure.

La première portion 26, 27 délimite par sa surface inférieure le plan d'appui 25 selon lequel la cellule est destinée à venir en appui dans un logement du spectromètre de RMN 1. Le premier élément 26 représente la majeure partie de la première portion 26, 27 et est conformée pour permettre un bon placement de la cellule de mesure 20 dans le logement correspondant du spectromètre de RMN. Ainsi, le premier élément 26 comporte des orifices conformés pour coopérer avec des organes de placement du logement du spectromètre de RMN. Le premier élément comporte en outre un évidement au niveau de son sommet pour le placement du deuxième élément et des passages adaptés pour alimenter le système de bobine 222 du deuxième élément 27. Dans une réalisation pratique, le premier élément 26 peut être réalisé dans un matériau plastique tel que, et à titre non limitatif, du Polyméthacrylate de méthyle ou PMMA, un Acrylonitrile butadiène styrène ou ABS, et un Polypropylène ou PP. Bien entendu, d'autres matériaux, tels que les verres et les céramiques peuvent être envisagés pour réaliser le premier élément 26.

Le deuxième élément 27 comporte une canalisation 221 du réseau de canalisations 23 de la cellule de mesure 20, cette canalisation 221 étant préférentiellement adaptée pour être neutre vis-à-vis de la mesure de RMN, et le système de bobine 222 pour générer un champ électromagnétique dans ladite canalisation. Le deuxième élément est donc disposé dans l'évidement du premier élément avec les deux extrémités de sa canalisation ouverte de manière à pouvoir coopérer avec le reste du réseau de canalisation ménagé dans la deuxième portion 28. Pour une réalisation pratique, le deuxième élément 27 peut être par exemple formé par un tube en verre ou en quartz autour duquel est monté le système de bobine 222. Avec de telles matières les risques de perturbation par les parois de la chambre de mesure de la mesure de RMN sont fortement réduits.

La deuxième portion 28 comporte le reste du réseau de canalisations 23 et la zone d'introduction de gaz 21, la canalisation d'introduction de gaz 231 y étant aménagée. La deuxième portion 28 se présente sous la forme d'une structure centrale 281 dans laquelle sont aménagées les canalisations du réseau de canalisations 23 autres que celle incluse dans le deuxième élément. On peut ainsi voir sur les figures 4A et 4B, que la deuxième portion comporte deux canalisations sensiblement perpendiculaires au plan d'appui 25, la canalisation d'introduction de gaz incluse et la première partie 214a de l'aire d'extraction de gaz 214 qui s'étend sensiblement parallèle au plan d'appui 25. Dans une réalisation pratique, cette structure verticale 281 peut être réalisée dans un matériau plastique tel que ; et à titre non limitatif, du Polyméthacrylate de méthyle ou PMMA, un Acrylonitrile butadiène styrène ou ABS, et un Polypropylène ou PP. Bien entendu, d'autres matériaux, tels que les verres et les céramiques peuvent être également envisagés pour réaliser la structure verticale 281.

La deuxième portion 28 comporte également un conduit d'amenée de gaz 212 et un conduit formant la sortie de gaz 213. Ces deux conduits s'étendent sensiblement perpendiculairement au plan d'appui 25, le premier dans la canalisation d'introduction de gaz 231, le deuxième dans l'aire d'extraction, et comportent tous deux une extrémité qui fait saillie de la structure verticale 281 pour permettre le branchement à un réseau d'alimentation en gaz 32.

Dans cette conception pratique, la deuxième portion 28 comporte une pièce de fermeture 282 dans laquelle la partie supérieure du conduit d'amenée de gaz 212 et le conduit formant la sortie de gaz 213 sont logées et qui permet de fermer l'aire d'extraction de gaz 214. Dans une réalisation pratique, cette pièce de fermeture 282 peut être réalisée dans un matériau plastique tel que, et à titre non limitatif, du Polyméthacrylate de méthyle ou PMMA, un Acrylonitrile butadiène styrène ou ABS, et un Polypropylène ou PP. Bien entendu, d'autres matériaux, tels que les verres et les céramiques peuvent être également envisagés pour réaliser la pièce de fermeture 282.

Une cellule de mesure 20 selon cette conception pratique présente l'avantage de pouvoir être fabriquée à faible coût en raison des matériaux pouvant être utilisés. Il est donc possible de prévoir une cellule à usage unique évitant ainsi tout risque de contamination inhérent à la réutilisation de cellules de mesure. On peut également noter que sa conception la rend compatible avec les technologies d'impression trois dimensions (prototypage rapide ou technologies additives) réduisant ainsi d'autant les coûts de fabrication en petite quantité, tout en autorisant un prototypage rapide et permettant une adaptation aisée aux contraintes technologiques.

Une telle cellule de mesure peut être fabriquée au moyen d'un procédé de fabrication comportant les étapes suivantes :
- fourniture de la deuxième portion 28 ceci de manière à fournir le réseau de canalisations 23, une canalisation 221 incluse dans chambre de mesure 22 étant exclue, l'entrée de gaz 211 étant aménagée dans ledit réseau de canalisations 23,
- fourniture du premier élément 26 de la première portion 26, 27,
- fourniture du deuxième élément 27 de la première portion 26, 27 ceci pour fournir la canalisation 221 incluse dans la chambre de mesure 22 et un système de bobine 222 permettant de générer un champ électromagnétique radiofréquence,
- assemblage du premier et du deuxième élément 26, 27 de la première portion 26, 27 pour former la première portion 26, 27,
- assemblage de la première et la deuxième portion 26, 27, 28 pour former la cellule de mesure 20, cet assemblage permettant de connecter le réseau de canalisations 23, la canalisation 221 formant la chambre de mesure 22 exclue, avec la canalisation 221 comprise dans la chambre de mesure 22 et de former le réseau de canalisations 23.

Les figures 5A et 5B illustrent une cellule de mesure selon une deuxième conception pratique du principe de l'invention dans lequel la cellule de mesure 20 comprend dans la zone d'introduction de gaz un système de filtration pour filtrer les bulles. Une cellule de mesure 20 selon cette deuxième conception pratique se différencie vis-à-vis de celle selon la première conception pratique en ce qu'elle comprend dans l'aire d'extraction de gaz 214 le système de filtration et en ce que la conduite d'amenée 212 n'est pas logée dans la canalisation d'introduction de gaz mais dans deux canalisations périphériques débouchant dans la canalisation d'introduction de gaz.

Ainsi, la cellule de mesure 20 selon cette deuxième conception pratique se différencie de celle de la première conception pratique uniquement de par sa deuxième portion 28, la première portion 26, 27 étant identique à celle de la cellule de mesure selon la première conception pratique. Pour cette raison la figure 5A n'illustre que cette deuxième portion 28.

La deuxième portion 28 de la cellule de mesure selon cette deuxième conception comporte dans l'aire d'extraction de gaz 214 une grille de filtration 215 dont le maillage est adapté pour filtrer la solution lors de son passage de la zone d'introduction de gaz 21 dans les canalisations du réseau de canalisation 23 amenant la solution à la chambre de mesure 22.

La grille de filtration 215 est configurée pour retenir les éventuelles bulles de gaz qui pourrait être emportées en dehors de la zone d'introduction de gaz en raison d'une circulation de la solution importante. Pour ce faire, la grille de filtration 215 présente une maille inférieure à la taille minimum des bulles générées dans la zone d'introduction de gaz. Ainsi par exemple, la maille de la grille de filtration 215 peut être choisie comme étant inférieure à 1 mm et sensiblement égale à 0,5 mm voire à 0,25 mm. En effet les bulles de gaz présentent généralement un diamètre de 2 à 3 mm.

La grille de filtration 215 est disposée dans l'aire d'extraction de gaz 214 de manière à intercepter la solution lors de sa circulation dans la zone d'introduction des gaz vers la chambre de mesure. Une telle disposition est fournie par la canalisation d'introduction de gaz débouchant dans une portion supérieure de la première partie 214a de l'air d'extraction 214, la canalisation reliant l'air d'extraction 214 et la chambre de mesure 22 étant en communication fluidique avec l'air d'extraction 214 sur une portion inférieure de la première partie 214a de l'air d'extraction 214, et la grille de filtration 215 étant disposées pour s'intercaler entre la portion supérieure et la portion supérieure pour intercepter la solution lors de son passage entre ces deux portions.

Avec une telle configuration, la grille de filtration 215 forme un système de filtration agencé dans le réseau de canalisations pour intercepter les bulles de gaz en sortie de la zone d'introduction de gaz dans la direction de circulation de la solution.

Bien entendu, si dans cette deuxième conception pratique, le système de filtration est formé par une grille de filtration, il peut également être formé par un autre type de système de filtration sans que l'on sorte de l'invention. Ainsi, il est parfaitement envisageable qu'il soit prévu dans la zone d'extraction, en lieu et place de la grille de filtration, une mousse de filtration adaptée pour filtrer les bulles ou encore l'utilisation d'une pluralité de canalisations dont le diamètre est suffisamment faible pour empêcher la circulation de bulles en direction de la chambre de mesure 22.

Une autre particularité de cette cellule selon cette deuxième conception pratique est que la deuxième portion 28 comporte une ou deux conduites d'amenée 212 de gaz fournissant dans la canalisation d'introduction de gaz 231 deux entrées de gaz 211. De plus les deux conduites d'amenée 212 sont deux conduites périphériques. De cette manière, les conduites d'amenée 212 ainsi intégrées dans la deuxième portion 28 ne posent aucun obstacle quant à la circulation de la solution dans le circuit de canalisations 23 et permet d'éviter les pertes de charge qui seraient induites par l'occupation en volume du conduit d'amenée de gaz. On notera de plus que la présence de deux entrées de gaz 211 permet l'utilisation de deux gaz différents, tels qu'un gaz présentant des propriétés magnétiques hors équilibre et de l'oxygène pour alimenter des cellules. Ces d'augmenter la quantité de gaz introduite

En variante, l'une de ces deux entrées de gaz 211 peut être utilisée non pas pour une introduction de gaz mais pour une introduction de liquide pour, par exemple, compenser une éventuelle évaporation. De la même façon, ces deux entrées de gaz 211 peuvent également être utilisées pour permettre d'augmenter le débit de gaz introduit et ainsi la vitesse de circulation de la solution. Une telle augmentation de la quantité de gaz introduite et de la vitesse de circulation n'engendre pas d'augmentation des risques de présence de bulles de gaz dans la chambre de mesure 22 ceci en raison de la grille de filtration 215.

On peut noter que dans le mode de réalisation et les conceptions pratiques décrits ci-dessus la cellule de mesure est, lors d'une mesure de RMN, entièrement comprise dans le champ magnétique statique du spectromètre de RMN qu'elle équipe. Il est néanmoins également envisageable, ceci sans sortir du cadre de l'invention, qu'une seule partie du volume de la cellule soit comprise dans le champ magnétique statique du spectromètre de RMN, ladite partie étant dite volume de détection. Selon cette possibilité de l'invention, la cellule de mesure comporte alors dans ledit volume de détection la zone d'introduction de gaz et la chambre de mesure avec au moins une partie d'un réseau de canalisations mettant en communication fluidique la zone d'introduction de gaz et la chambre de mesure.

De même, dans le mode de réalisation et les conceptions pratiques décrits ci-dessus, la circulation de la solution 33 à mesurer est obtenue au moyen uniquement de l'introduction de gaz dans la solution 33. Il est néanmoins envisageable, sans sortir du cadre de l'invention que la circulation de fluide dans le réseau de canalisations puisse être obtenue par un autre moyen venant en complément, ou à la place, de celui offert par l'introduction de gaz. Ainsi par exemple, il peut être prévu un système de mise en circulation de fluide tel qu'un système de seringue et de pousse seringue ou encore une pompe péristaltique.

Pour finir, les cellules de mesure selon le mode de réalisation et selon les conceptions pratiques décrites ci-dessus ne comportent, pour des raisons de simplification, qu'une seule chambre de mesure. Il peut, bien entendu, également être prévu, dans les limites de dimensionnement liées au spectromètre de RMN à équiper, plusieurs chambres de mesure sans que l'on sorte du cadre de l'invention.

## Revendications

1. Cellule de mesure (20) de Résonance Magnétique Nucléaire, ou RMN, en solution (33) autorisant l'introduction d'un gaz dans ladite solution (33), la cellule de mesure (20) étant destinée à être placé dans un champ magnétique statique tel que celui d'un spectromètre de RMN (1), et comprenant:
- au moins une chambre de mesure (22) de la solution dans laquelle un champ électromagnétique radiofréquence est destiné à être appliqué et/ou à être mesuré,
- au moins une canalisation pour la solution en communication fluidique avec la chambre de mesure (22), ladite canalisation comportant une zone d'introduction (21) de gaz comprenant une entrée de gaz (211) pour générer des bulles uniquement dans la zone d'introduction des gaz,
la cellule de mesure (20) **étant caractérisée en ce qu**'elle comporte en outre :
- un réseau de canalisations incluant l'au moins une canalisation (23) et formant un circuit fermé de circulation de la solution (33) entre la chambre de mesure (22) et la zone d'introduction de gaz, l'entrée des gaz étant agencée de manière à entrainer une circulation de la solution (33) dans le réseau de canalisations (23) entre la zone d'introduction de gaz (21) et la chambre de mesure (22), la chambre de mesure (22) comprend une canalisation du réseau de canalisations, dite de mesure,
- un système radiofréquence (222) agencé pour appliquer et/ou détecter un champ électromagnétique radiofréquence dans la canalisation de mesure.

2. Cellule de mesure (20) selon la revendication 1, dans laquelle la zone d'introduction de gaz (21) comporte en outre une sortie de gaz (213) en communication fluidique avec le réseau de canalisations (23) qui est destinée à être hors solution.

3. Cellule de mesure (20) selon la revendication 2, dans laquelle la chambre de mesure (22) est configurée de manière à ce que le rapport de distances de circulation de la solution (33) dans le réseau de canalisations (23) de la chambre de mesure (20) de la distance de circulation de la chambre de mesure (22) vers l'entrée de gaz (211) sur la distance de circulation de la sortie de gaz (213) vers la chambre de mesure (20) est inférieur à 1, celui-ci étant préférentiellement inférieur à 0,5 et encore plus préférentiellement inférieur à 0,2.

4. Cellule de mesure (20) selon la revendication 2 ou 3, dans laquelle la cellule de mesure (20) comporte une embase (24) pour son installation dans un spectromètre de RMN (1) définissant un plan d'appui (25), et dans laquelle la zone d'introduction de gaz (21) comporte une canalisation (231) du réseau de canalisations (23), dite d'introduction de gaz, qui s'étend transversalement, voire sensiblement perpendiculairement, au plan d'appui (25), l'entrée de gaz (211) se trouvant dans la canalisation d'introduction de gaz (231) proche de l'embase (24) par rapport à la sortie des gaz (213).

5. Cellule de mesure (20) selon la revendication 4 comportant un conduit d'amenée de gaz (212) disposé dans la canalisation d'introduction de gaz (231) dont une première extrémité débouche dans la canalisation d'introduction de gaz et forme l'entrée de gaz (211).

6. Cellule de mesure (20) selon la revendication 4 ou 5, dans laquelle la canalisation d'introduction des gaz (231) débouche dans une aire d'extraction de gaz (214) dont une première partie (214a) délimite une canalisation du réseau de canalisations (23) et une seconde partie (214b) est destinée à être hors solution, la sortie de gaz (213) étant disposée dans ladite seconde partie (214b).

7. Cellule de mesure (20) selon l'une quelconque des revendications 1 à 6 comportant un corps réalisée en deux portions (26, 27, 28), une première portion (26, 27) formant embase pour l'installation de la cellule de mesure (20) dans un spectromètre de RMN (1) et dans laquelle est ménagée la chambre de mesure (22), et une deuxième portion (28) comportant la zone d'introduction des gaz (21), lesdites première et deuxième portions (26, 27, 28) étant complémentaires en forme de manière à ce que le réseau de canalisations (23) soit formé par l'assemblage de la première et la deuxième portion (26, 27, 28).

8. Cellule de mesure (20) selon la revendication 7, dans laquelle la première portion (26, 27) comporte un premier et un deuxième élément (26, 27), le premier élément (26) formant l'enveloppe extérieure de la première portion (26, 27), le deuxième élément (27) comportant la chambre de mesure (22) et le système radiofréquence (222).

9. Cellule de mesure (20) selon l'une quelconque des revendications 1 à 8 comprenant en outre dans la zone d'introduction de gaz un système de filtration agencé dans le réseau de canalisations pour intercepter les bulles de gaz en sortie de la zone d'introduction de gaz dans la direction de circulation de la solution.

10. Cellule de mesure (20) selon la revendication 9 dans lequel le système de filtration comprend une grille de filtration (215) dont la maille est inférieure à 1 mm voire à 0,5 mm.

11. Cellule de mesure (20) selon l'une quelconque des revendications 1 à 8 dans laquelle la cellule de mesure (20) comporte :
- une embase (24) pour son installation dans un spectromètre de RMN (1) définissant un plan d'appui (25),
- au moins deux canalisations, une première canalisation (231) dite d'introduction de gaz, et une deuxième canalisation (232) qui s'étendent toutes deux transversalement, voire sensiblement perpendiculairement, au plan d'appui (25), la canalisation d'introduction de gaz comportant une entrée des gaz afin de former des bulles dans la première canalisation et ainsi former la zone d'introduction de gaz,
- au moins une troisième et une quatrième canalisation (233, 234) reliant la première et la deuxième canalisation au niveau de leurs extrémités se trouvant respectivement à proximité de l'embase et à distance de l'embase, ceci de manière à former un circuit fermé de circulation de la solution et a ainsi former le réseau de canalisations,
- le système radiofréquence (222) agencé dans la zone de mesure (22) pour appliquer et/ou détecter un champ électromagnétique radiofréquence dans une portion de la troisième canalisation de manière à définir une chambre de mesure.

12. Procédé de fabrication d'une cellule de mesure comportant les étapes consistant à :
- fournir un système radiofréquence (222),
- fournir une canalisation (23) dite de mesure pour former la canalisation de mesure,
- agencer le système radiofréquence vis-à-vis de la canalisation de mesure de manière à ce le système radiofréquence (222) soit agencé pour appliquer et/ou détecter un champ électromagnétique radiofréquence dans la canalisation de mesure (23) de manière à former une chambre de mesure (22),
- fournir des canalisations supplémentaires pour former un réseau de canalisations avec la canalisation de mesure (23), ledit réseau de canalisation incluant une canalisation pour la solution en communication fluidique avec la chambre de mesure (22), ladite canalisation comportant une zone d'introduction de gaz comprenant une entrée de gaz pour générer des bulles uniquement dans la zone d'introduction des gaz, le réseau de canalisations formant un circuit fermé de circulation de la solution (33) entre la chambre de mesure (22) et la zone d'introduction de gaz, l'entrée des gaz étant agencée de manière à entrainer une circulation de la solution (33) dans le réseau de canalisations (23) entre la zone d'introduction de gaz (21) et la chambre de mesure (22),
- former la cellule de mesure en assemblant les canalisations supplémentaires avec l'ensemble formé lors de l'agencement du système radiofréquence vis-à-vis de la canalisation de mesure.

13. Procédé de fabrication d'une cellule de mesure (20) selon la revendication 12 dans lequel :
l'étape de fourniture des canalisations supplémentaires pour former un réseau de canalisations avec la canalisation de mesure (23), consiste à fournir le réseau de canalisations (23), une canalisation incluse dans la chambre de mesure (22) exclue, l'entrée de gaz (211) étant aménagé dans ledit réseau de canalisations (23), lesdites canalisation supplémentaire formant un premier élément
l'étape d'agencement du système radiofréquence vis-à-vis de la canalisation de mesure de manière à ce le système radiofréquence (222) de la chambre de mesure (22) consiste à former un deuxième élément (27) comportant la canalisation incluse dans la chambre de mesure (22) et un système radiofréquence (222) apte à générer et/ou à mesurer un champ radiofréquence,
l'étape de formation de la cellule de mesure (20) consiste à assembler le réseau de canalisations (23), la canalisation incluse dans la chambre de mesure (22) exclue, avec le deuxième élément (27) comportant la canalisation incluse dans la chambre de mesure (22).

14. Ensemble de mesure par Résonance Magnétique Nucléaire, ou RMN, en solution (33) comportant :
- un spectromètre de RMN, ou équivalent, adapté pour générer un premier champ magnétique statique, et
- une cellule de mesure de RMN en solution (33),
- un système d'introduction de gaz,
l'ensemble **étant caractérisé en ce que** la cellule de mesure est une cellule selon l'une quelconque des revendications 1 à 11 présentant son entrée de gaz (211) connectée au système d'introduction de gaz.

## Patentansprüche

1. Messzelle (20) zur Kernspinresonanz- bzw. NMR-Messung in Lösung (33), die das Einleiten eines Gases in die Lösung (33) gestattet, wobei die Messzelle (20) dazu bestimmt ist, in einem statischen Magnetfeld, wie dem eines NMR-Spektrometers (1), angeordnet zu werden, und enthält:
- zumindest eine Messkammer (22) zum Messen der Lösung, in der ein elektromagnetisches Hochfrequenzfeld angelegt und/oder gemessen werden soll,
- zumindest eine Rohrleitung für die Lösung in Fluidverbindung mit der Messkammer (22), wobei die Rohrleitung eine Gaseinleitungszone (21) umfasst, die einen Gaseinlass (211) aufweist, um Blasen nur in der Gaseinleitungszone zu erzeugen,
wobei die Messzelle (20) **dadurch gekennzeichnet ist, dass** sie ferner enthält:
- ein Rohrleitungsnetz (23), das die zumindest eine Rohrleitung umfasst und einen geschlossenen Kreislauf für die Zirkulation der Lösung (33) zwischen der Messkammer (22) und der Gaseinleitungszone bildet, wobei der Gaseinlass so angeordnet ist, dass eine Zirkulation der Lösung (33) in dem Rohrleitungsnetz (23) zwischen der Gaseinleitungszone (21) und der Messkammer (22) hervorgerufen wird, wobei die Messkammer (22) eine Rohrleitung des Rohrleitungsnetzes, Messrohrleitung genannt, enthält,
- ein Hochfrequenzsystem (222), das dazu angeordnet ist, das elektromagnetische Hochfrequenzfeld in der Messrohrleitung anzulegen und/oder zu erfassen.

2. Messzelle (20) nach Anspruch 1, wobei die Gaseinleitungszone (21) ferner einen Gasauslass (213) in Fluidverbindung mit dem Rohrleitungsnetz (23) enthält, der sich außerhalb der Lösung befinden soll.

3. Messzelle (20) nach Anspruch 2, wobei die Messkammer (22) so ausgebildet ist, dass das Verhältnis der Strömungsstrecken der Lösung (33) im Rohrleitungsnetz (23) von der Messkammer (20) zwischen der Strömungsstrecke von der Messkammer (22) zum Gaseinlass (211) und der Strömungsstrecke vom Gasauslass (213) zur Messkammer (20) kleiner als 1, vorzugsweise kleiner als 0,5 und noch bevorzugter kleiner als 0,2 ist.

4. Messzelle (20) nach Anspruch 2 oder 3, wobei die Messzelle (20) eine Basis (24) für deren Einsetzen in einem NMR-Spektrometer (1) aufweist, die eine Auflageebene (25) definiert, und wobei die Gaseinleitungszone (21) eine Rohrleitung (231) des Rohrleitungsnetzes (23), Gaseinleitrohrleitung genannt, aufweist, die sich quer bzw. im Wesentlichen senkrecht zu der Auflageebene (25) erstreckt, wobei der Gaseinlass (211) in der Gaseinleitrohrleitung (231) in der Nähe der Basis (24) in Bezug auf den Gasauslass (213) angeordnet ist.

5. Messzelle (20) nach Anspruch 4, enthaltend eine in der Gaseinleitrohrleitung (231) angeordnete Gaszuführleitung (212), deren erstes Ende in die Gaseinleitrohrleitung mündet und den Gaseinlass (211) bildet.

6. Messzelle (20) nach Anspruch 4 oder 5, wobei die Gaseinleitrohrleitung (231) in einen Gasausleitbereich (214) mündet, von dem ein erster Abschnitt (214a) eine Rohrleitung des Rohrleitungsnetzes (23) begrenzt und ein zweiter Abschnitt (214b) dazu bestimmt ist, sich außerhalb der Lösung zu befinden, wobei der Gasauslass (213) in diesem zweiten Abschnitt (214b) angeordnet ist.

7. Messzelle (20) nach einem der Ansprüche 1 bis 6, enthaltend einen Körper, der aus zwei Abschnitten (26, 27, 28) besteht, wobei ein erster Abschnitt (26, 27) eine Basis zum Einsetzen der Messzelle (20) in ein NMR-Spektrometer (1) bildet und in welchem die Messkammer (22) ausgebildet ist, und ein zweiter Abschnitt (28) die Gaseinleitungszone (21) umfasst, wobei der erste und der zweite Abschnitt (26, 27, 28) eine komplementäre Form aufweisen, so dass das Rohrleitungsnetz (23) durch das Zusammenfügen des ersten und des zweiten Abschnitts (26, 27, 28) gebildet wird.

8. Messzelle (20) nach Anspruch 7, wobei der erste Abschnitt (26, 27) ein erstes und ein zweites Element (26, 27) umfasst, wobei das erste Element (26) die äußere Hülle des ersten Abschnitts (26, 27) bildet und das zweite Element (27) die Messkammer (22) und das Hochfrequenzsystem (222) umfasst.

9. Messzelle (20) nach einem der Ansprüche 1 bis 8, ferner enthaltend in der Gaseinleitungszone ein in dem Rohrleitungsnetz angeordnetes Filtersystem zum Abfangen von Gasblasen am Auslass der Gaseinleitungszone in Strömungsrichtung der Lösung.

10. Messzelle (20) nach Anspruch 9, wobei das Filtersystem ein Filtergitter (215) mit einer Maschengröße von weniger als 1 mm bzw. 0,5 mm aufweist.

11. Messzelle (20) nach einem der Ansprüche 1 bis 8, wobei die Messzelle (20) enthält:
- eine Basis (24) für deren Einsetzen in ein NMR-Spektrometer (1), die eine Auflageebene (25) definiert,
- zumindest zwei Rohrleitungen, nämlich eine erste Rohrleitung (231), Gaseinleitrohrleitung genannt, und eine zweite Rohrleitung (232), die sich beide quer bzw. im Wesentlichen senkrecht zur Auflageebene (25) erstrecken, wobei die Gaseinleitrohrleitung einen Gaseinlass aufweist, um in der ersten Rohrleitung Blasen zu bilden und so die Gaseinleitungszone zu bilden,
- zumindest eine dritte und eine vierte Rohrleitung (233, 234), die die erste und die zweite Rohrleitung an ihren Enden verbinden, die sich jeweils in der Nähe der Basis und in einem Abstand von der Basis befinden, um einen geschlossenen Kreislauf für die Zirkulation der Lösung zu bilden und so das Rohrleitungsnetz zu bilden,
- das im Messbereich (22) angeordnete Hochfrequenzsystem (222) zum Anlegen und/oder Erfassen eines elektromagnetischen Hochfrequenzfeldes in einem Abschnitt der dritten Rohrleitung, um eine Messkammer zu definieren.

12. Verfahren zum Herstellen einer Messzelle mit den folgenden Schritten:
- Bereitstellen eines Hochfrequenzsystems (222),
- Bereitstellen einer Rohrleitung (23), Messrohrleitung genannt, um die Messrohrleitung zu bilden,
- Anordnen des Hochfrequenzsystems gegenüber der Messrohrleitung derart, dass das Hochfrequenzsystem (222) dazu angeordnet ist, ein elektromagnetisches Hochfrequenzfeld in der Messrohrleitung (23) anzulegen und/oder zu erfassen, um eine Messkammer (22) zu bilden,
- Bereitstellen von zusätzlichen Rohrleitungen, um ein Rohrleitungsnetz mit der Messrohrleitung (23) zu bilden, wobei das Rohrleitungsnetz eine Rohrleitung für die Lösung in Fluidverbindung mit der Messkammer (22) umfasst, wobei die Rohrleitung eine Gaseinleitungszone mit einem Gaseinlass zur Erzeugung von Blasen nur in der Gaseinleitungszone aufweist, wobei das Rohrleitungsnetz einen geschlossenen Kreislauf für die Zirkulation der Lösung (33) zwischen der Messkammer (22) und der Gaseinleitungszone bildet, wobei der Gaseinlass so angeordnet ist, dass die Zirkulation der Lösung (33) im Rohrleitungsnetz (23) zwischen der Gaseinleitungszone (21) und der Messkammer (22) hervorgerufen wird,
- Ausbilden der Messzelle durch Zusammenfügen der zusätzlichen Rohrleitungen mit der Baugruppe, die bei Anordnung des Hochfrequenzsystems gegenüber der Messrohrleitung (23) gebildet wird.

13. Verfahren zum Herstellen einer Messzelle (20) nach Anspruch 12, wobei der Schritt des Bereitstellens der zusätzlichen Rohrleitungen zum Bilden des Rohrleitungsnetzes mit der Messrohrleitung (23) darin besteht, das Rohrleitungsnetz (23) ohne eine in der Messkammer (22) enthaltende Rohrleitung bereitzustellen, wobei der Gaseinlass (211) in dem Rohrleitungsnetz (23) angeordnet ist und die zusätzlichen Rohrleitungen ein erstes Element bilden,
der Schritt des Anordnens des Hochfrequenzsystems gegenüber der Messrohrleitung mit dem Hochfrequenzsystem (222) und der Messkammer (22) darin besteht, ein zweites Element (27) zu bilden, das die in der Messkammer (22) enthaltene Rohrleitung und ein Hochfrequenzsystem (222) umfasst, das in der Lage ist, ein Hochfrequenzfeld zu erzeugen und/oder zu messen,
der Schritt des Ausbildens der Messzelle (20) darin besteht, das Rohrleitungsnetz (23) ohne die in der Messkammer (22) enthaltene Rohrleitung zusammenzufügen, wobei das zweite Element (27) die in der Messkammer (22) enthaltene Rohrleitung umfasst.

14. Messanordnung zur Kernspinresonanz- oder NMR-Messung in Lösung (33), enthaltend:
- ein NMR-Spektrometer oder dergleichen, das dazu ausgelegt ist, ein erstes statisches Magnetfeld zu erzeugen, und
- eine Messzelle zur NMR-Messung in Lösung (33),
- ein Gaseinleitsystem,
wobei die Anordnung **dadurch gekennzeichnet ist, dass** die Messzelle eine Zelle nach einem der Ansprüche 1 bis 11 ist, deren Gaseinlass (211) mit dem Gaseinleitsystem verbunden ist.

## Claims

1. Nuclear Magnetic Resonance (NMR) measurement cell (20) in solution (33) enabling the introduction of a gas into said solution (33), the measurement cell (20) being designed to be placed in a static magnetic field such as the field of an NMR spectrometer (1), and comprising:
- at least one measurement chamber (22) of the solution in which a radiofrequency electromagnetic field will be applied and/or measured,
- at least one conduit for the solution in fluidic communication with the measurement chamber (22), said conduit comprising an including a gas inlet zone, the gas introduction zone comprising a gas inlet to generate bubbles only in the gas introduction zone,
the measurement cell (20) being **characterised in that** it further incudes:
- network of conduits including the at t least one conduit and forming a closed circuit for circulation of the solution (33) between the measurement chamber (22) and the gas introduction zone, the gas inlet being arranged so as to set up circulation of the solution in the network of conduits between the gas introduction zone (21) and the measurement chamber (22), the measurement chamber (22) comprising a conduit of the network of conduits called the measurement conduit,
a radiofrequency system (222) arranged to apply and/or detect a radiofrequency electromagnetic field in the measurement conduit.

2. Measurement cell (20) according to claim 1, in which the gas introduction zone (21) further comprises a gas outlet (213) in fluidic communication with the network of conduits (23) that is intended to be outside the solution.

3. Measurement cell (20) according to claim 2, in which the measurement chamber (22) is configured such that the ratio between the circulation distance of the solution (33) in the conduit network (23) from the measurement chamber to the gas inlet (211) on the circulation distance from the gas outlet (213) to the measurement chamber (20) is less than 1, this ratio being preferably less than 0.5 and being more preferably less than 0.2.

4. Measurement cell (20) according to claim 2 or 3, in which the measurement cell (20) comprises a base (24) for its installation in an NMR spectrometer (1) defining a base plane, and in which the gas introduction zone (21) comprises a conduit (231) called the gas introduction conduit, in the network of conduits, that extends transverse or even approximately perpendicular to the base plane (25), the gas inlet (211) being located in the gas introduction conduit (231) closer to the base (24) than the gas outlet (213).

5. Measurement cell (20) according to claim 4 comprising a gas conveyance conduit (212) in the gas introduction conduit (231), a first end of which opens up into the gas introduction conduit and forms the gas inlet (211).

6. Measurement cell (20) according to claim 4 or 5, in which the gas introduction conduit (231) opens up into a gas extraction area (214) of which a first part (214a) delimits a conduit in the network of conduits (23) and a second part (214b) is intended to be outside solution, the gas outlet (213) being located in said second part (214b).

7. Measurement cell (20) according to any one form claims 1 to 6 comprising a body made in two portions (26, 27, 28), a first portion (26, 27) forming a base for installation of the measurement cell (20) in an NMR spectrometer (1) and in which the measurement chamber (27) is formed, and a second portion (28) comprising the gas introduction zone (21), said first and second portions (26, 27;28) having complementary shapes such that the network of conduits (23) is formed by the assembly of the first and the second portion (26, 27, 28).

8. Measurement cell (20) according to any one from claims 1 to 7, in which the first portion (26, 27) comprises a first and a second element (26, 27), the first element (26) forming the external casing of the first portion (26, 27), the second element (27) comprising the measurement chamber and the radiofrequency system (222).

9. Measurement cell according to any one from claims 1 to 8 also comprising a filtration system in the gas introduction zone formed in the network of conduits to intercept gas bubbles at the outlet from the gas introduction zone along the direction of circulation of the solution.

10. Measurement cell according to claim 9 in which the filtration system comprises a filtration grid with a mesh size smaller than 1 mm.

11. Nuclear Magnetic Resonance (NMR) measurement cell (20) according ot any one from claims 1 to 8, wherein the measurement cells comprises:
- a base (24) for its installation in an NMR spectrometer (1) defining a base plane,
- at least two conduits, a first conduit (231) called the gas introduction conduit, and a second conduit (232) both extending transversally, or perpendicularly, to the base plane (25), the gas introduction conduit comprising a gas inlet to form bubbles in the first conduit and thus form the gas introduction zone,
- at least a third and a fourth conduit (233, 234) connecting the first and second conduits at their ends located close to the base and at a distance from the base respectively, so as to form a network of conduits, the network of conduits forming a closed circulation circuit for the solution between the measurement chamber and the gas introduction zone,
- a radiofrequency system (222) formed in the measurement zone (22) to apply and/or detect a radiofrequency electromagnetic field in a portion of the third conduit so as to define a measurement chamber.

12. Method of manufacturing a measurement cell comprising the following steps:
- provide a radiofrequency system (222);
- provide a conduit (23) in which the measurement will be made, to form the measurement conduit;
- position the radiofrequency system relative to the measurement conduit such that the radiofrequency system (222) can apply and/or detect a radiofrequency electromagnetic field in the measurement conduit (23) so as to form a measurement chamber (22);
- provide additional conduits to form a network of conduits with the measurement conduit (23), said network of conduits including a conduit for the solution in fluidic communication with the measurement chamber (22), said conduit comprising a gas inlet zone comprising a gas inlet to generate bubbles only in the gas introduction zone, the network of conduits forming a closed circuit for circulation of the solution (33) between the measurement chamber (22) and the gas introduction zone, the gas inlet being arranged so as to set up circulation of the solution (33) in the network of conduits (23) between the gas introduction zone (21) and the measurement chamber (22);
- form the measurement cell by assembling the additional conduits with the assembly formed during positioning of the radiofrequency system relative to the measurement conduit.

13. Manufacturing method according to claim 12 in which:
- the step to provide additional conduits to form a network of conduits with the measurement conduit (23), consists of providing the network of conduits (23), excluding a conduit inside the measurement chamber (22), the gas inlet (23) being formed in said network of conduits (23), said additional conduits forming a first element,
the step to position the radiofrequency system relative to the measurement conduit such that the radiofrequency system (222) of the measurement chamber (22) consists of forming a second element (27) including the conduit inside the measurement chamber (22) and a radiofrequency system (222) capable of generating et/or measuring a radiofrequency field,
the step to form the measurement cell (20) consists of assembling the network of conduits (23), excluding the conduit inside the measurement chamber (22), with the second element (27) including the conduit inside the measurement chamber (22).

14. Nuclear Magnetic Resonance (NMR) measurement assembly for use with a solution (33) comprising:
- an NMR spectrometer, or equivalent, suitable for generating a first static magnetic field; and
- an NMR measurement cell in solution (33);
- a gas introduction system;
the measurement cell being **characterized in that** the measurement cell is a cell according to any one from claims 1 to 11 with its gas inlet (211) connected to the gas introduction system.
